# EUROPÄISCHE PATENTSCHRIFT

(11) **EP 2 878 051 B1**
(45) Veröffentlichungstag und Bekanntmachung des Hinweises auf die Patenterteilung: **03.10.2018**
(21) Anmeldenummer: 13742397.6
(22) Anmeldetag: 25.07.2013
(51) Int. Cl.: H02B 1/32, H02B 1/052, H02B 1/20

(54) **MONTAGESYSTEM FÜR DIE ANORDNUNG VON BEISPIELSWEISE ELEKTRISCHEN EINRICHTUNGEN INSBESONDERE IN SCHALTSCHRÄNKEN**
ASSEMBLY SYSTEM FOR THE MOUNTING OF E.G. ELECTRICAL DEVICES ESPECIALLY IN ELECTRICAL CABINETS
SYSTÈME D'ASSEMBLAGE POUR LE MONTAGE D'ÉQUIPEMENTS ÉLECTRIQUES EN PARTICULIER DANS DES ARMOIRES ÉLECTRIQUES

(30) Priorität: 25.07.2012 DE 102012014980
(43) Veröffentlichungstag der Anmeldung: 03.06.2015
(73) Patentinhaber: Friedrich Lütze GmbH, 71366 Weinstadt-Grossheppach (DE)
(72) Erfinder: LÜTZE, Udo, 71394 Kernen-Stetten (DE); LANG, Jürgen, 71640 Ludwigsburg (DE); GHIZELEA, Virgil, 70372 Stuttgart (DE)
(74) Vertreter: Bartels und Partner, Patentanwälte
(86) Internationale Anmeldenummer: PCT/EP2013/002209
(87) Internationale Veröffentlichungsnummer: WO 2014/015987

(56) Entgegenhaltungen:
- DE-A1- 10 350 465
- DE-A1- 19 908 350
- DE-U1- 29 716 229
- DE-U1-202010 011 620
- JP-U- S5 978 819

## Beschreibung

Die Erfindung betrifft ein Montagesystem für die Anordnung von beispielsweise elektrischen Einrichtungen insbesondere in Schaltschränken.

In der industriellen Steuerungstechnik werden elektrische Geräte häufig in Schaltschränken oder Schaltkästen angeordnet. Die einzelnen Einrichtungen werden auf Tragschienen wie beispielsweise einer Hutschiene angeordnet und können aneinander gereiht werden. Anschließend werden die Einrichtungen verdrahtet, wobei ein kammartiges Ordnungsmittel an dem die Tragschiene aufweisenden Montagesteg angebracht ist, um die Verbindungsleitungen der Einrichtungen zu ordnen. Ein zugehöriges Montagesystem wird von der Anmelderin Friedrich Lütze GmbH in 71384 Weinstadt angeboten und ist beispielsweise aus der DE 297 16 229 U1, der DE 103 50 465 A1 oder auch der DE 20 2008 015 309 U1 bekannt.

Die DE 199 08 350 A1 der Schutzrechtsinhaberin beschreibt ein Montagesystem für die Anordnung von beispielsweise elektrischen Einrichtungen insbesondere in Schaltschränken, wobei das Montagesystem mindestens einen horizontal verlaufenden, geraden Montagesteg aufweist, an dem mindestens eine Einrichtung anbringbar ist, und wobei der Montagesteg an einem ersten, in einem Schnitt quer zur Längsachse durch den Montagesteg vorzugsweise mittigen Abschnitt eine Tragschiene aufweist, an der die Einrichtung lösbar festlegbar ist, wobei ein von der Tragschiene beabstandeter dritter Abschnitt des Montagesteges einen größeren Höhenabstand von dem Fußpunkt der Tragschiene aufweist als ein zwischen dem ersten Abschnitt und dritten Abschnitt angeordneter zweiter Abschnitt an seinem der Tragschiene nahen, insbesondere an die Tragschiene angrenzenden, Ende.

Ein weiteres Montagesystem geht aus der JP S59-78819 U hervor.

Der vorliegenden Erfindung liegt die Aufgabe zugrunde, ein neues Montagesystem bereitzustellen, das verbesserte Gebrauchseigenschaften aufweist, insbesondere vielseitig einsetzbar ist und dabei dennoch einfach in der Handhabung und Montage ist. In einer Ausführungsart soll das Anordnen der Einrichtungen an der Tragschiene des Montagesteges weiter vereinfacht sein und eine weiter erhöhte Flexibilität aufweisen. Außerdem soll das Wärmemanagement der Einrichtungen weiter verbessert sein.

Die Aufgabe ist durch das im Anspruch 1 bestimmte Montagesystem gelöst. Besondere Ausführungsarten der Erfindung sind in den Unteransprüchen bestimmt.

Gemäß dem Kennzeichen von Anspruch 1 ist vorgesehen, dass der Montagesteg mindestens abschnittsweise eine konvexe Krümmung aufweist und dass dadurch der erste Abschnitt des Montagesteges mit der Tragschiene nach außen gewölbt ist.

In einer Ausführungsart weist das Montagesystem mindestens einen vorzugsweise horizontal verlaufenden Montagesteg auf, gegebenenfalls auch mehrere parallel verlaufende Montagestege, an denen Einrichtungen anbringbar sind. Der Montagesteg weist an einem ersten, in einem Schnitt quer zur Längsachse durch den Montagesteg vorzugsweise mittigen Abschnitt eine Tragschiene auf, beispielsweise eine genormte oder eine einer Norm im Wesentlichen entsprechenden Hutschiene, an der die Einrichtungen lösbar festlegbar sind. Die Montagestege können an einer Trageinrichtung festlegbar sein, beispielsweise an rechtwinklig zu den Montagestegen und vorzugsweise vertikal verlaufenden Profilstäben. Die Montagestege können zusammen mit den Profilstäben einen Montagerahmen bilden, der vormontierbar ist und anschließend in beispielsweise einen Schaltschrank einsetzbar ist.

In einer Ausführungsart ist der Montagesteg derart ausgebildet und insbesondere geformt, dass ein von der Tragschiene beabstandeter dritter Abschnitt des Montagesteges einen größeren Höhenabstand von dem Fußpunkt der Tragschiene aufweist als ein zwischen dem ersten und dritten Abschnitt angeordneter zweiter Abschnitt an seinem der Tragschiene nahen, insbesondere an die Tragschiene angrenzenden Ende. Der Fußpunkt der Tragschiene, die einstückig von dem Montagesteg ausgebildet sein kann, ist beispielsweise durch den Übergang der Tragschiene auf den an die Tragschiene anschließenden zweiten Bereich des Montagestegs gebildet.

Der Fußpunkt der Tragschiene bildet eine Bezugshöhe, gegenüber welcher sich der Abschnitt der Tragschiene, der beim Festlegen der Einrichtung mit der Einrichtung zusammenwirkt, abhebt, beispielsweise um 7,5 oder 15 mm abhebt. Der von der Tragschiene beabstandete und beispielsweise an oder nahe einem randseitigen Ende des Montagestegs angeordnete dritte Abschnitt des Montagesteges liegt auf der in Bezug auf die Bezugshöhe gegenüberliegenden Seite des mit der Einrichtung zusammenwirkenden Abschnitts der Tragschiene.

Der Höhenabstand des dritten Abschnitts von der Bezugshöhe kann dabei mehr als 50 % und weniger als 200 %, insbesondere mehr als 80 % und weniger als 125 % und vorzugsweise etwa 100 % des Höhenabstandes des beim Festlegen der Einrichtung mit der Einrichtung zusammenwirkenden Abschnitts der Tragschiene betragen. Der laterale Abstand des dritten Abschnitts von der Tragschiene entspricht in einem Ausführungsbeispiel etwa der halben maximal zulässigen Bauhöhe der an der Tragschiene festzulegenden Einrichtung.

Der Montagesteg kann die konvexe Krümmung insbesondere in dem zwischen dem ersten und dritten Abschnitt angeordneten zweiten Abschnitt aufweisen.

Der Montagesteg kann beispielsweise aus einem Profilstab gebildet sein und aus Aluminium oder einer aluminiumhaltigen Legierung hergestellt sein. Der Montagesteg kann im Profil symmetrisch zu einer Mittelebene sein. Alternativ oder ergänzend kann das Montagesystem auch Montagestege umfassen, die unsymmetrisch zu einer Mittelebene sind, insbesondere solche, deren Tragschiene und/oder Gleitmutterkanal zwar symmetrisch zu einer Mittelebene sind, deren laterale Erstreckung ausgehend von der Mittelebene jedoch unterschiedlich ist.

Die konvexe Krümmung kann sich mindestens einseitig, vorzugsweise beidseitig, über einen Winkelbereich von mehr als 8° und weniger als 30° erstrecken, insbesondere mehr als 10° und weniger als 25°, und vorzugsweise mehr als 12° und weniger als 20°. In einer Ausführungsart erstreckt sich die konvexe Krümmung beidseitig über etwa 15°. Bei unsymmetrischen Profilen des Montagesteges kann der Winkel auf einer Seite größer sein, insbesondere die Krümmung stärker, als auf der anderen Seite.

In einer Ausführungsart beträgt der Radius der konvexen Krümmung mehr als das Zweifache, insbesondere mehr als das Dreifache und vorzugsweise etwa oder sogar mehr als das Vierfache der lateralen Erstreckung des gekrümmten zweiten Abschnitts.

Durch das erfindungsgemäße Profil des Montagesteges sind trotz einer relativ geringen Höhe der Tragschiene von beispielsweise 7,5 mm auch Einrichtungen mit einer großen Bauform, insbesondere mit einer großen Bauhöhe, an dem Montagesteg festlegbar, weil die Einrichtungen beim Aufsetzen auf die Tragschiene nicht in blockierende Anlage an den Montagesteg kommen, insbesondere nicht in blockierende Anlage an den zweiten Abschnitt des Montagestegs. Es ist besonders vorteilhaft, dass unterschiedlich große Einrichtungen an ein und derselben Tragschiene festlegbar sind, insbesondere dass nicht beispielsweise für große Einrichtungen eine Tragschiene mit einer größeren Tragschienenhöhe bereitgestellt werden muss. Dadurch entfällt die Notwendigkeit, Montagestege mit unterschiedlicher Höhe der Tragschiene vorzuhalten und bei Bedarf einzusetzen oder sogar ein bereits montiertes Montagesystem durch Austausch eines Montagesteges umzubauen. Darüber hinaus wird aufgrund des erfindungsgemäßen Profils des Montagesteges der Abstand der Einrichtung zu dem Montagesteg vergrößert, wodurch die Kühlung der Einrichtung verbessert ist und damit das Wärmemanagement des Montagesystems.

In einer Ausführungsart weist der Montagesteg entlang seiner Längserstreckung eine Nut zum lösbar rastenden Einsetzen von Bezeichnungsschildern auf. Dadurch ist eine zuverlässige Kennzeichnung der festgelegten Einrichtungen und/oder deren Verbindungsleitungen vereinfacht. Die Bezeichnungsschilder können entlang der Nut verschoben und an der gewünschten Stelle platziert werden.

In einer Ausführungsart weist die Nut einen Hinterschnitt auf, in den die in die Nut einsetzbaren Bezeichnungsschilder mit federnd auslenkbaren Schenkeln rastend eingreifen. Dadurch ist die Montage der Bezeichnungsschilder weiter vereinfacht, insbesondere sind die Bezeichnungsschilder entweder werkzeuglos oder mit einfachen Werkzeugen und geringen Kräften lösbar und anbringbar.

In einer Ausführungsart ist die Nut im Bereich des dritten Abschnitts des Montagesteges angeordnet oder in dem vom ersten Abschnitt fernen Ende des zweiten Abschnitts des Montagesteges. Dadurch ist gewährleistet, dass auch bei festgelegter Einrichtung das Bezeichnungsschild jederzeit ablesbar ist. Weiterhin kann das Bezeichnungsschild auch bei festgelegter Einrichtung angebracht oder gelöst werden.

In einer Ausführungsart weist der Montagesteg an mindestens einem von der Tragschiene fernen freien Ende eine Aufnahmeeinrichtung für ein an dem Montagesteg festlegbares Ordnungsmittel auf zum Ordnen der Verbindungsleitungen der an dem Montagesteg angebrachten Einrichtungen.

Bei den Einrichtungen kann es sich beispielsweise um elektrische Einrichtungen handeln, etwa Stromversorgungen, Sicherungen, Steuerungen, Ein-Ausgabe-Baugruppen, Schnittstelleneinheiten, Temperaturwandler, Analog/Digital-Wandler oder dergleichen. Alternativ oder ergänzend kann die Vorrichtung auch nicht-elektrische Komponenten aufweisen, beispielsweise optische Komponenten oder pneumatische Komponenten.

Weitere Vorteile, Merkmale und Einzelheiten der Erfindung ergeben sich aus den Unteransprüchen und der nachfolgenden Beschreibung, in der unter Bezugnahme auf die Zeichnungen mehrere Ausführungsbeispiele im Einzelnen beschrieben sind. Dabei können die in den Ansprüchen und in der Beschreibung erwähnten Merkmale jeweils einzeln für sich oder in beliebiger Kombination erfindungswesentlich sein.
- Fig. 1: zeigt eine perspektivische Ansicht auf ein Ausführungsbeispiel eines Montagesystems;
- Fig. 2: zeigt einen Montagesteg in vergrößerter Darstellung;
- Fig. 3: zeigt ein Ausführungsbeispiel eines ersten Ordnungsmittels;
- Fig. 4: zeigt eine perspektivische Ansicht auf einen Montagesteg mit einem eingesetzten Ordnungsmittel;
- Fig. 5: zeigt den Montagesteg der Fig. 4 mit einem ausgetauschten Ordnungssegment;
- Fig. 6: zeigt eine Ansicht auf ein weiteres Ordnungssegment;
- Fig. 7: zeigt einen Schnitt durch einen Montagesteg mit dem daran festgelegten Ordnungssegment der Fig. 6;
- Fig. 8: zeigt in vergrößerter Darstellung einen Ausschnitt aus der Fig. 7;
- Fig. 9: zeigt eine Ansicht auf ein weiteres Ordnungssegment;
- Fig. 10: zeigt einen Schnitt durch einen Montagesteg mit dem daran festgelegten Ordnungssegment der Fig. 9;
- Fig. 11: zeigt in vergrößerter Darstellung einen Ausschnitt aus der Fig. 10;
- Fig. 12: zeigt eine Ansicht auf eine weitere Komponente;
- Fig. 13: zeigt einen Schnitt durch einen Montagesteg mit der daran festgelegten weiteren Komponente der Fig. 12;
- Fig. 14: zeigt in vergrößerter Darstellung einen Ausschnitt aus der Fig. 13;
- Fig. 15: zeigt eine Seitenansicht auf einen Montagesteg nach dem Stand der Technik;
- Fig. 16: zeigt eine Seitenansicht auf eine Schalttafel nach dem Stand der Technik;
- Fig. 17: zeigt eine Seitenansicht auf ein Ausführungsbeispiel eines Montagesteges während des Anbringens einer Einrichtung;
- Fig. 18: zeigt eine Seitenansicht auf ein Ausführungsbeispiel eines Montagesteges mit daran angebrachter Einrichtung;
- Fig. 19: zeigt eine perspektivische Ansicht auf einen Montagesteg;
- Fig. 20: zeigt eine Seitenansicht auf den Montagesteg der Fig. 19;
- Fig. 21: zeigt einen Ausschnitt aus der Fig. 20 in vergrößerter Darstellung;
- Fig. 22: zeigt eine perspektivische Ansicht auf ein Ende des Montagesteges;
- Fig. 23: zeigt eine Seitenansicht auf den Montagesteg der Fig. 22;
- Fig. 24: zeigt einen Ausschnitt aus der Fig. 23 in vergrößerter Darstellung;
- Fig. 25: zeigt eine perspektivische Ansicht auf die Rückseite des Montagesystems der Fig. 1;
- Fig. 26: zeigt eine Seitenansicht auf einen Montagesteg der Fig. 25;
- Fig. 27: zeigt eine Seitenansicht auf einen Montagesteg mit einem auf die Raststege aufgerasteten Adapterelement;
- Fig. 28: zeigt eine perspektivische Ansicht auf die Rückseite des Montagesteges mit zwei aufgerasteten Adapterelementen;
- Fig. 29: zeigt eine zweite weitere Komponente des Montagesystems, die nicht Teil der Erfindung ist;
- Fig. 30: zeigt eine Seitenansicht des Montagesteges mit einem auf der Rückseite mittels Adapterelementen befestigten Kabelkanal, der nicht Teil der Erfindung ist;
- Fig. 31: zeigt eine perspektivische Ansicht auf ein weiteres Ausführungsbeispiel eines Montagesystems;
- Fig. 32: zeigt eine Seitenansicht auf ein Beispiel eines Montagesteges ohne Tragschiene; und
- Fig. 33: zeigt eine Seitenansicht auf ein weiteres Ausführungsbeispiel eines unsymmetrischen Montagesteges.

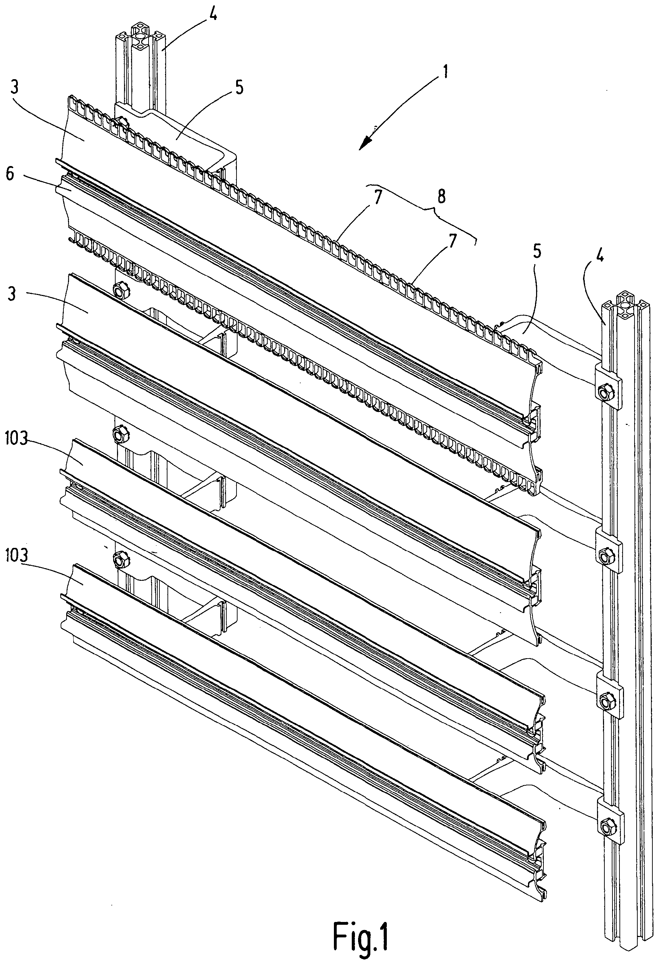

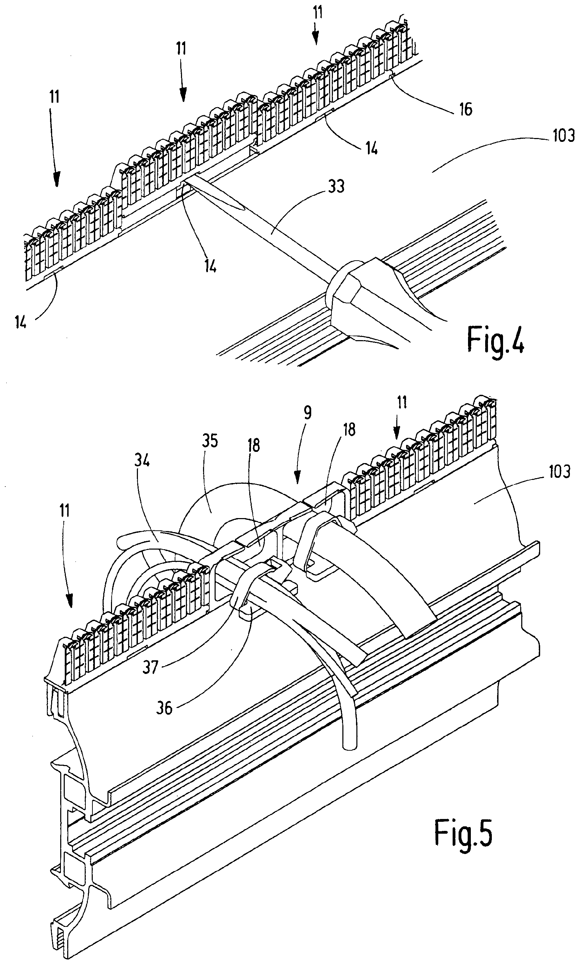

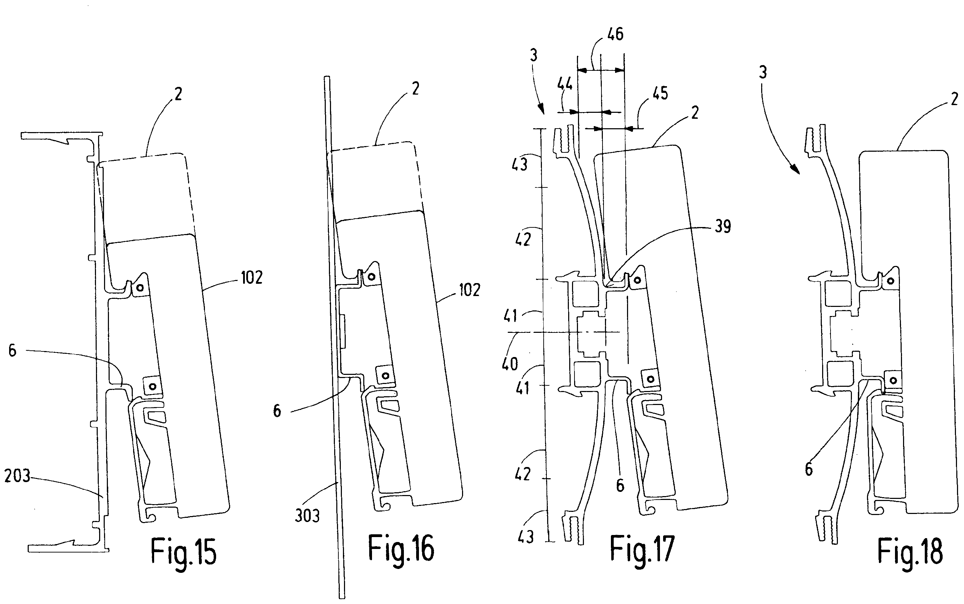

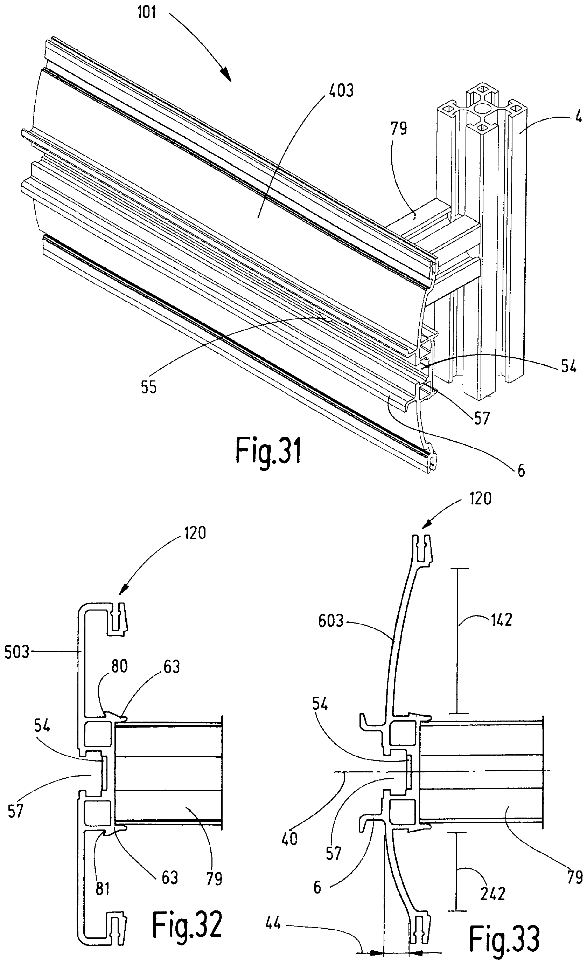

Die Figur 1 zeigt eine perspektivische Ansicht auf ein Ausführungsbeispiel eines Montagesystems 1, das insgesamt vier horizontal verlaufende Montagestege 3, 103 aufweist, an denen jeweils mindestens eine Einrichtung 2 (Fig. 17) anbringbar ist. Die beiden unteren Montagestege 103 weisen eine geringere laterale Erstreckung auf gegenüber den beiden oberen Montagestegen 3. Die Montagestege 3, 103 sind an oder nahe ihren beiden Enden, beispielsweise bis 200 mm und insbesondere bis 125 mm von ihren beiden Enden entfernt, mittels jeweils eines Montagebügels 5 oder einem sonstigen Verbindungselement 79 (Fig. 31) mit jeweils einem vertikal verlaufenden Profilstab 4 verbunden und bilden zusammen mit den Profilstäben 4 einen Montagerahmen, der vormontierbar ist und anschließend in dem in der Fig. 1 dargestellten Zustand oder auch mit bereits daran angebrachten Einrichtungen 2 und deren Verbindungsleitungen 34, 35 (Fig. 5) in einen Schaltschrank einsetzbar ist. Die Montagestege 3, 103 weisen jeweils eine Tragschiene 6 auf, an welcher die Einrichtungen 2 anzubringen sind, im Ausführungsbeispiel eine genormte oder eine einer Norm im Wesentlichen entsprechenden Hutschiene mit einer Höhe der Hutschiene von 7,5 mm.

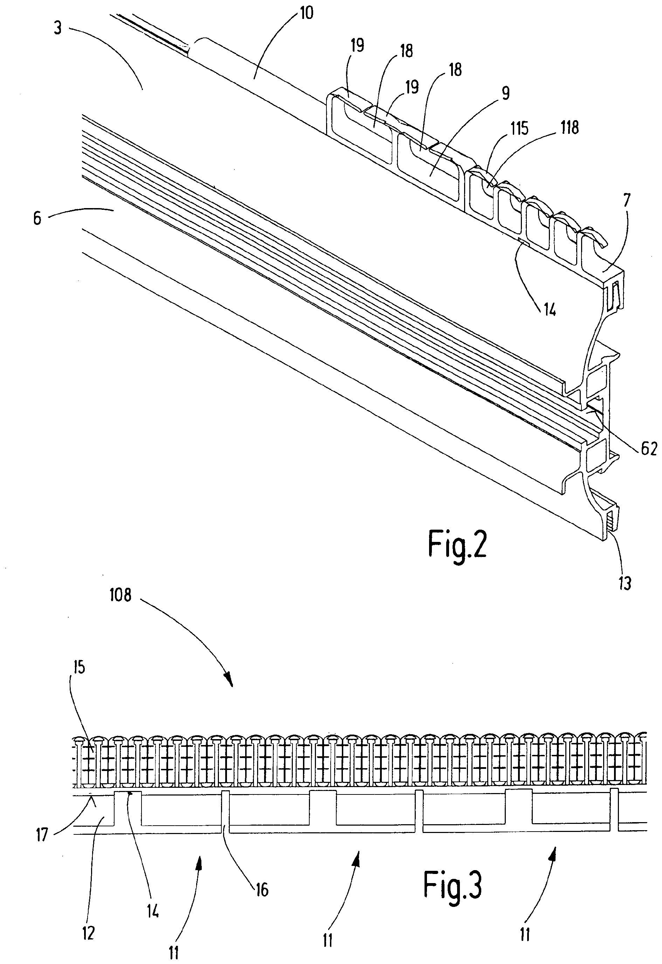

An den Längsrändern des in der Fig. 1 oberen Montagesteges 3 ist jeweils ein Ordnungsmittel 8 angebracht, das aus einer Vielzahl gleichartig ausgebildeter Ordnungssegmente 7 zusammengesetzt ist. Aus dem Ordnungsmittel 8 sind wahlweise einzelne oder mehrere Ordnungssegmente 7 lösbar und von dem Ordnungsmittel 8 bzw. dem Montagesteg 3 unter Zurücklassen einer Lücke entfernbar oder gegen ein anderes Ordnungssegment 9 (Fig. 2), 11 (Fig. 3) oder eine Gruppe von anderen Ordnungssegmenten 9, 11 austauschbar.

Die Fig. 2 zeigt einen Montagesteg 3 in vergrößerter Darstellung. Die Fig. 3 zeigt ein Ordnungsmittel 108, das durch eine Vielzahl einstückig ausgebildeter und hintereinander angeordneter Ordnungssegmente 11 zusammengesetzt ist. Anstelle der einstückigen Ausbildung können die Ordnungssegmente 11 auch an ihren Enden jeweils Verkettungsmittel aufweisen, mittels denen die Ordnungssegmente 11 lösbar miteinander verkettet sind. Das Ordnungsmittel 108 kann in vorgebbaren Längen von beispielsweise etwa 1 m oder 2 m hergestellt sein oder auch endlos hergestellt sein.

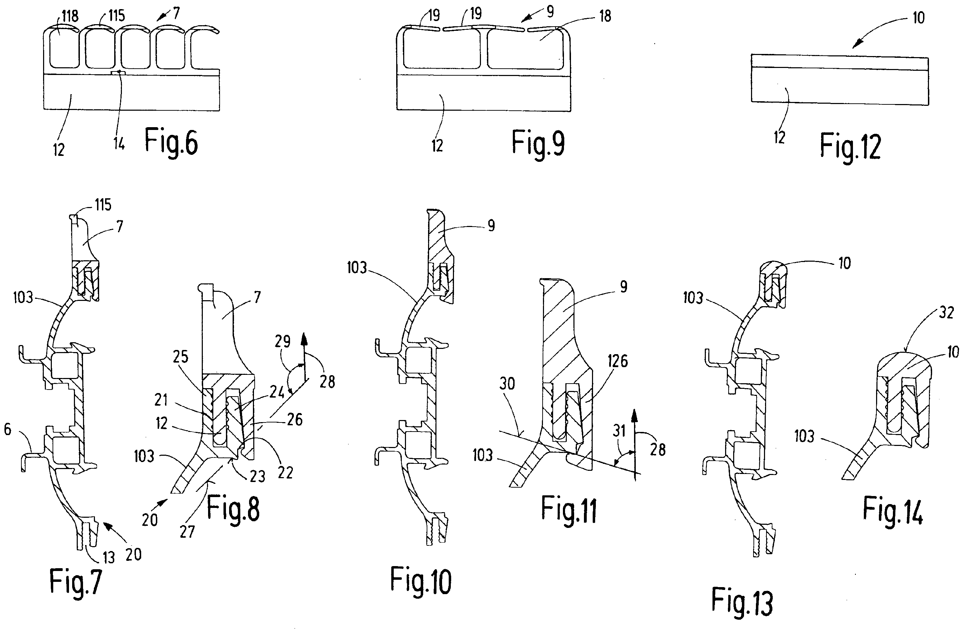

Jedes Ordnungssegment 11 weist einen stegförmigen Festlegeabschnitt 12 auf, der in eine an den Längsrändern des Montagesteges 3 angeordnete und eine Nut 13 (Fig. 7) aufweisende Aufnahmeeinrichtung 20 einsteckbar ist. Mittig in Bezug auf die Längserstreckung ist in den Festlegeabschnitt 12 eine in Einsteckrichtung verlaufende Nut 14 eingebracht, deren eine Werkzeugangriffsfläche bildendes Ende auch im eingesteckten Zustand zugänglich bleibt und in welche ein Werkzeug 33 (Fig. 4) zum Lösen des Ordnungssegments 11 einführbar ist.

Einstückig mit dem Festlegeabschnitt 12 bildet das Ordnungssegment 11 vorzugsweise federelastisch auslenkbare Ordnungselemente 15 aus, zwischen denen Verbindungsleitungen 34, 35 der Einrichtung 2 einsteckbar und dadurch geordnet fixierbar sind. Solltrennstellen 16, an denen die Ordnungssegmente 11 vereinzelt werden können, sind durch Einschnitte in den Festlegeabschnitt 12 gebildet. Die Einschnitte ragen dabei über eine von dem Ordnungssegment 11 gebildete Anschlagkante 17 hinaus, bis zu welcher das Ordnungssegment 11 in die Nut 13 einsteckbar ist. Dadurch ist die Position der Solltrennstelle 16 auch im eingesteckten Zustand sichtbar. Ein Trennschnitt kann aus Richtung der Ordnungselemente 15 erfolgen.

Das Ordnungssegment 9 weist zwei sich jeweils über die halbe Länge des Ordnungssegments 9 erstreckende Aufnahmekammern 18 für die zu ordnenden Verbindungsleitungen 34, 35 auf. Zwei dem Montagesteg 3 bzw. dem Festlegeabschnitt 12 gegenüberliegende Schenkel 19 des Ordnungssegments 9 sind federelastisch auslenkbar zum Einführen der zu ordnenden Verbindungsleitungen 34, 35 in die Aufnahmekammer 18. Demgegenüber weist das Ordnungssegment 7 eine Vielzahl, im Ausführungsbeispiel fünf Ordnungselemente 115 auf, die jeweils einen elastisch verformbaren Hakenabschnitt zum Verschließen der Aufnahmekammer 118 aufweisen. Weitere Ordnungssegmente können auch unterschiedlich ausgestaltete Aufnahmekammern 18, 118 aufweisen, insbesondere unterschiedlich große Aufnahmekammern 18, 118, beispielsweise eine oder mehrere größere Aufnahmekammern 18 identisch oder ähnlich wie das Ordnungssegment 9 und eine oder mehrere kleinere Aufnahmekammern 118 identisch oder ähnlich wie das Ordnungssegment 7. In einer Ausführungsart beträgt die Längserstreckung der einzelnen Aufnahmekammern 18, 118 mindestens 5 %, insbesondere mindestens 8 % und vorzugsweise mindestens 10 % der gesamten Längserstreckung des Ordnungssegments 7, 9. Bei der weiteren Komponente 10 des Montagesystems 1 handelt es sich um ein Kantenschutzelement. Die Ordnungssegmente 7, 9 weisen ebenso wie die weitere Komponente 10 eine übereinstimmende Länge von im Ausführungsbeispiel 50 mm auf.

Die Fig. 4 zeigt eine perspektivische Ansicht auf einen Montagesteg 103 mit einem durch ein Aneinanderreihen von Ordnungssegmenten 11 gebildeten und in die Nut 13 eingesetzten Ordnungsmittel 108. Ein Ordnungssegment 11 wurde dabei durch zwei Schnitte an den Sollbruchstellen 16 vereinzelt und durch Einsetzen eines Werkzeuges 33, beispielsweise der Klinge eines Schlitz-Schraubendrehers, kann das vereinzelte Ordnungssegment 11 gelöst und von dem Montagesteg 103 entnommen werden.

Die Fig. 5 zeigt eine perspektivische Ansicht auf den Montagesteg 103 der Fig. 4, wobei anstelle des in der Fig. 4 gelösten Ordnungssegments 11 ein Ordnungssegment 9 mit zwei großen Aufnahmekammern 18 eingesetzt ist, in die ein Bündel von Verbindungsleitungen 34 bzw. eine Verbindungsleitung 35 mit großem Querschnitt eingesetzt sind.

Zur besseren Fixierung der Verbindungsleitungen 34, 35 weist das Ordnungssegment 9 einen quer zur Längsrichtung vorspringenden, insbesondere auf die Vorderseite des Montagesteges 103 mit der Tragschiene 6 vorspringenden Halteabschnitt 36 auf. Das Ordnungssegment 9 weist für jede Aufnahmekammer 18 einen Halteabschnitt 36 auf. Der Halteabschnitt 36 ist an seinem freien Ende T-förmig ausgebildet zur besseren Fixierung eines Haltemittels 37, bei dem es sich um einen Kabelbinder handeln kann.

Die Figuren 6, 9 und 12 zeigen die Ordnungssegmente 7, 9 sowie die weitere Komponente 10 in einer Ansicht. Das Ordnungssegment 9 und die weitere Komponente 10 sind unlösbar an dem Montagesteg 3 festlegbar, weshalb diese Komponenten 9, 10 keine Werkzeugangriffsfläche 14 aufweisen.

Die Fig. 7 zeigt einen Schnitt durch einen Montagesteg 103 mit einem daran festgelegten Ordnungssegment 7. Die Fig. 8 zeigt in vergrößerter Darstellung einen Ausschnitt aus der Fig. 7 im Bereich der Verbindung des Ordnungssegments 7 mit dem Montagesteg 103. Die sich entlang der Längsachse des Montagesteges 103 erstreckende und einstückig von dem Montagesteg 103 ausgebildete Aufnahmeeinrichtung 20, in welche das Ordnungssegment 7 einsteckbar ist, weist neben der Nut 13, deren Seitenwände mehrere sich in Längsrichtung des Montagesteges 103 erstreckende weitere Nuten 21 oder Riffelungen aufweisen, auf einer Außenseite der Aufnahmeeinrichtung 20 zwei Rastflanken 22, 23 auf, die sich in Längsrichtung des Montagesteges 103 erstrecken und einstückig von diesem ausgebildet sind. Insbesondere sind die beiden Rastmittel 22, 23 auf einer Außenseite einer die Nut 13 begrenzenden Wand 24 gebildet, die in lateraler Richtung gegenüber der gegenüberliegenden und die Nut 13 ebenfalls begrenzenden Wand 25 zurückversetzt ist. Auf der Außenseite weist die Wand 24 eine schräg zur Einsteckrichtung des Ordnungssegments 7 und insbesondere schräg zur Nut 13 verlaufende Fläche auf. Durch die Schrägstellung ist ein Auslenken des Rastmittels 26 beim Einstecken des Ordnungssegments 7 mit geringer Einsteckkraft möglich.

Das Ordnungssegment 7, das eine Komponente erster Art des Montagesystems 1 bildet, weist ein zugehöriges Rastmittel 26 auf, das durch einen im unverformten Ausgangszustand nahezu parallel zu dem Festlegeabschnitt 12 verlaufenden, aber diesem gegenüber federelastisch auslenkbaren Schenkel gebildet ist, nahe dessen freiem Ende eine Rastflanke 27 erster Art gebildet ist, die mit der Richtung 28 der Zugkraft einen Winkel 29 von mehr als 90° einschließt, und dadurch das Verrasten allein durch Zugkraft lösbar ist. Zur vereinfachten Handhabung kann die Lösekraft durch einen in die Werkzeugangriffsfläche 14 einsteckbaren Schlitz-Schraubendreher 33 aufgebracht werden.

Die Fig. 10 zeigt einen Schnitt durch einen Montagesteg 103 mit einem daran festgelegten Ordnungssegment 9. Die Fig. 11 zeigt in vergrößerter Darstellung einen Ausschnitt aus der Fig. 10 im Bereich der Verbindung des Ordnungssegments 9 mit dem Montagesteg 103. Das Ordnungselement 9 bildet eine Komponente zweiter Art des Montagesystems 1 mit einem zugehörigen Rastmittel 126, das eine Rastflanke 30 zweiter Art aufweist, die mit der Richtung 28 der Zugkraft einen Winkel von weniger als 90° einschließt und dadurch das Verrasten allein durch Zugkraft nicht lösbar ist, sondern selbsthemmend ist. Dementsprechend ist das Ordnungselement 9 mit hoher Festigkeit an dem Montagesteg 3 festgelegt, entsprechend den großen Aufnahmekammern 18 für das Einbringen großer und schwerer Verbindungsleitungen 34, 35.

Die Fig. 13 zeigt einen Schnitt durch einen Montagesteg 103 mit einer daran festgelegten weiteren Komponente 10. Die Fig. 14 zeigt in vergrößerter Darstellung einen Ausschnitt aus der Fig. 13 im Bereich der Verbindung der weiteren Komponente 10 mit dem Montagesteg 103. Bei der weiteren Komponente 10 handelt es sich um ein Kantenschutzelement, das auf seiner von dem Montagesteg 103 wegweisenden Oberfläche eine sich über einen Winkelbereich von 180° erstreckende konvexe, aber von der Kreisform abweichende Oberfläche 32 aufweist. Die weitere Komponente 10 kann beispielsweise als Extrusionsteil aus einem Kunststoff hergestellt sein und individuell auf die gewünschte Länge abgelängt sein. Die weitere Komponente 10 weist keine Werkzeugangriffsfläche 14 auf, so dass eine Lösbarkeit der Verrastung durch eine Zugkraft in Richtung 28 zwar grundsätzlich möglich ist, aber aufgrund des verwendeten Werkstoffes und der konstruktiven Ausgestaltung manuell nicht oder nur mit großem Kraftaufwand möglich ist. Dies soll verhindern, dass die weitere Komponente 10 versehentlich von dem Montagesteg 103 gelöst werden kann.

In einer Ausführungsart ist bei jenen Ordnungssegmenten 7, 11 oder Komponenten, bei welchen in dem am Montagesteg 3, 103 festgelegten Zustand die Werkzeugangriffsfläche 14 sichtbar ist, das Verrasten nicht-selbsthemmend sondern allein durch Zugkraft lösbar, insbesondere weisen jene Ordnungssegmente 7, 11 ein Rastmittel 26 mit einer Rastflanke 27 erster Art auf, durch die das Verrasten allein durch Zugkraft lösbar ist.

Die Fig. 15 und 16 zeigen eine Seitenansicht auf einen Montagesteg 203 nach dem Stand der Technik bzw. auf eine Schalttafel 303 nach dem Stand der Technik, die jeweils eine Tragschiene 6 mit einer Höhe von beispielsweise 7,5 mm aufweisen. Bedingt durch die relativ geringe Höhe der Tragschiene 6 sind Einrichtungen 2 mit einer vergleichsweise großen Bauhöhe nicht festlegbar, sondern allenfalls Einrichtungen 102, die zumindest einseitig eine reduzierte Bauhöhe aufweisen. Um das Problem zu lösen, auch bei Tragschienen 6 mit einer vergleichsweise geringen Bauhöhe große Einrichtungen 2 festlegen zu können, weist ein vorzugsweise symmetrisch zu einer Mittelebene 40 aufgebauter Montagesteg 3 neben einem ersten vorzugsweise mittigen Abschnitt 41, in dem auch die Tragschiene 6 ausgebildet ist, einen von der Tragschiene 6 beabstandeten dritten Abschnitt 43 auf, der einen größeren Höhenabstand 44 von dem Fußpunkt 39 der Tragschiene 6 aufweist als ein zwischen dem ersten Abschnitt 41 und dritten Abschnitt 43 angeordneter zweiter Abschnitt 42 an seinem der Tragschiene 6 nahen, insbesondere an seinem an die Tragschiene 6 angrenzende Ende.

Im Ausführungsbeispiel der Fig. 17 und 18 wird dies durch eine konvexe Krümmung des Montagesteges 3 insbesondere in seinem zweiten Abschnitt 42 erreicht. Die konvexe Krümmung erstreckt sich über einen Winkelbereich von etwa 15°, und der Radius der konvexen Krümmung beträgt etwa das Vierfache der lateralen Erstreckung des gekrümmten zweiten Abschnitts 42. Der Höhenabstand 44 zwischen einem dem dritten Abschnitt 43 zugewandten Ende des zweiten Abschnitts 42 und einem dem ersten Abschnitt 41 zugewandten Ende des zweiten Abschnitts 42 entspricht dabei ungefähr der Höhe 45 der Tragschiene 6, so dass die Gesamthöhe 46 für das Anbringen der Einrichtung 2 an der Tragschiene 6 etwa das Doppelte der Höhe 45 der Tragschiene 6 beträgt. Wie die Figuren 17 und 18 zeigen, sind trotz der relativ geringen Höhe 45 der Tragschiene 6 problemlos Einrichtungen 2 mit großer Bauform an dem Montagesteg 3 festlegbar.

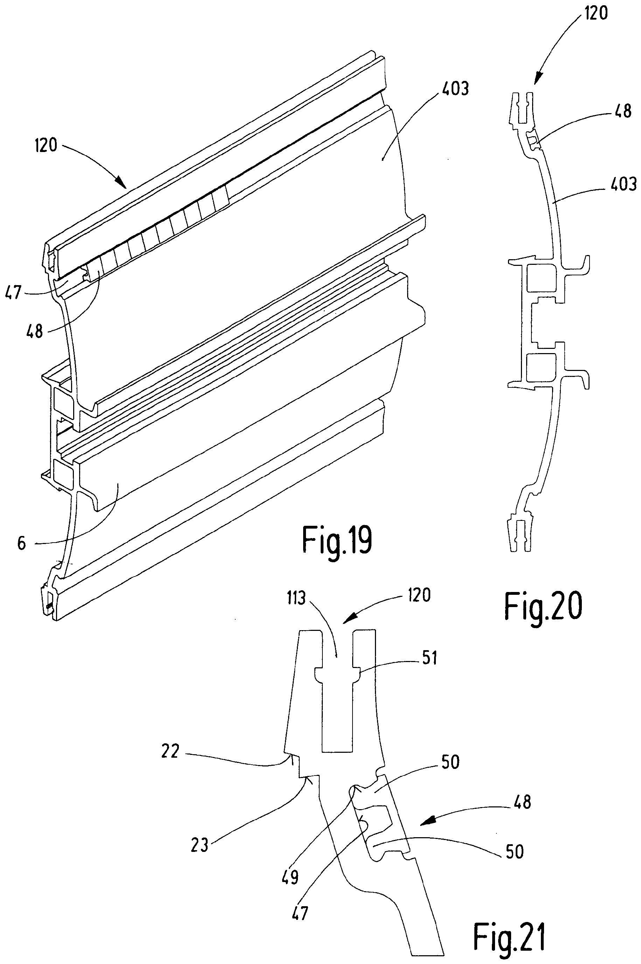

Die Fig. 19 zeigt eine perspektivische Ansicht auf einen Montagesteg 403. Die Fig. 20 zeigt eine Seitenansicht auf den Montagesteg 403 der Fig. 19. Die Fig. 21 zeigt einen Ausschnitt aus der Fig. 20 in vergrößerter Darstellung im Bereich einer von dem Montagesteg 403 einstückig ausgebildeten Nut 47 zum lösbar rastenden Einsetzen von Bezeichnungsschildern 48. Die Nut 47 weist dabei beidseitig einen Hinterschnitt 49 auf, in den jeweils ein federelastisch auslenkbarer Schenkel 50 des Bezeichnungsschilds 48 rastend eingreift. Die Nut 47 ist im Bereich des dritten Abschnitts 43 des Montagesteges 403 angeordnet oder in einem vom ersten Abschnitt 41 fernen Ende des zweiten Abschnitts 42 des Montagesteges 403. Dadurch ist gewährleistet, dass auch bei an dem Montagesteg 403 festgelegter Einrichtung 2 das Bezeichnungsschild 48 ablesbar ist. Das Bezeichnungsschild 48 kann beispielsweise eine Verbindungsleitung 35, 36 kennzeichnen, die benachbart zu dem Bezeichnungsschild 48 von der Rückseite auf die Vorderseite des Montagesteges 403 geführt ist, oder eine im Bereich des Bezeichnungsschilds 48 an der Tragschiene angeordnete Einrichtung 2.

In die Aufnahmeeinrichtung 120 sind Ordnungsmittel 8 oder sonstige Komponenten 10 des Montagesystems 1 einsetzbar, insbesondere in die Einstecknut 113 einsteckbar. Mindestens eine der Wände, welche die Einstecknut 113 begrenzen, weist eine oder mehrere, sich vorzugsweise in Längsrichtung der Einstecknut 113 erstreckende Vertiefungen 51 oder Riffelungen auf, beispielsweise zum unlösbaren Verrasten einer in die Aufnahmeeinrichtung 120 einsetzbaren bzw. in die Einstecknut 113 einsteckbaren Komponente des Montagesystems 1. Außenseitig weist auch die Aufnahmeeinrichtung 120 eine erste Rastflanke 22 und eine zweite Rastflanke 23 auf, wobei die erste nicht hemmende Rastflanke 22 einen geringeren Abstand von dem freien Ende der Aufnahmeeinrichtung 120 aufweist gegenüber der hemmenden zweiten Rastflanke 23.

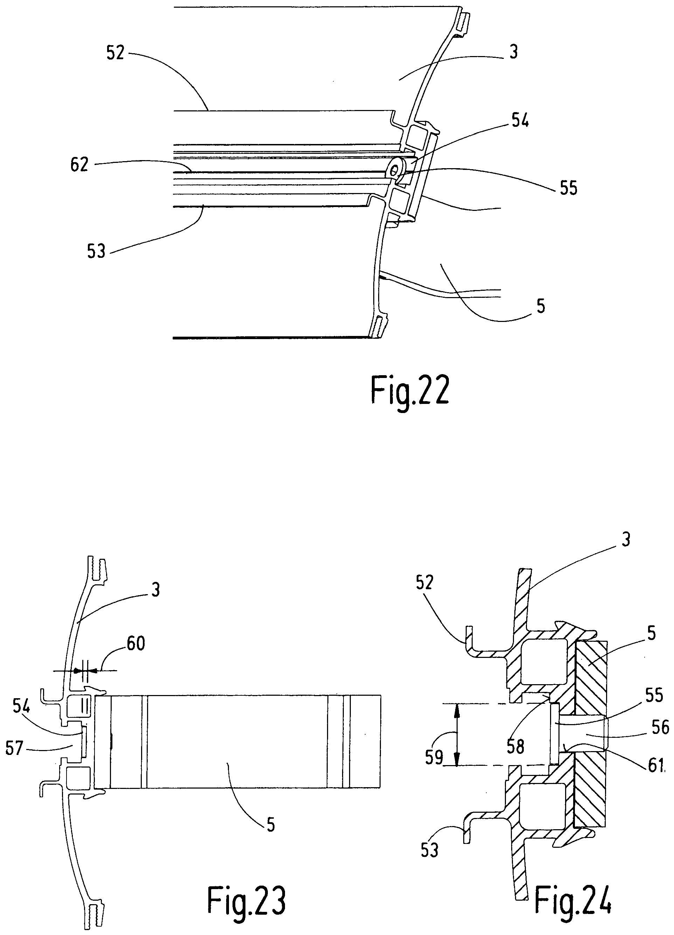

Die Fig. 22 zeigt eine perspektivische Ansicht auf ein Ende des Montagesteges 3 mit der Verbindung mit dem Montagebügel 5. Die Fig. 23 zeigt eine Seitenansicht auf den Montagesteg 3 der Fig. 22, und die Fig. 24 zeigt einen Ausschnitt der Fig. 23 in vergrößerter Darstellung im Bereich der Verbindung zwischen Montagesteg 3 und Montagebügel 5. Der Montagesteg 3 weist zwischen den beiden Tragschenkeln 52, 53 der Tragschiene 6 eine in Längsrichtung des Montagesteges 3 und vorzugsweise mittig verlaufende Nut 54 auf, die einen Kopf 55 eines Verbindungsmittels 56, insbesondere den Kopf einer Flachkopfschraube aufnimmt. Dadurch ragt der Kopf 55 in einem den Montagesteg 3 mit dem Montagebügel 5 verbundenen Zustand nicht in den Bereich zwischen den beiden Tragschenkeln 52, 53 hinein und behindert dadurch nicht das Anbringen der Einrichtung 2.

Im Ausführungsbeispiel weist der Montagesteg 3 zwischen den beiden Tragschenkeln 52, 53 einen in Längsrichtung des Montagesteges 3 verlaufenden Gleitmutterkanal 57 auf. Die Nut 54 ist in die Bodenfläche 58 des Gleitmutterkanals 57 eingebracht. Der Kopf 55 des Verbindungsmittels 56 ragt im verbundenen Zustand nicht über die Bodenfläche 58 des Gleitmutterkanals 57 hinaus bzw. nicht in den Gleitmutterkanal 57 hinein. Dadurch ist auch bei montiertem Verbindungsmittel 56 das Einbringen einer oder mehrerer Gleitmuttern in den Gleitmutterkanal 57 möglich, insbesondere auch in einen beidseitig von Verbindungsmitteln 56 begrenzten Abschnitt des Gleitmutterkanals 57.

Die Breite 59 der Nut 54 ist weniger als 50 % größer als die Breite des Kopfes 55 des Verbindungsmittels 56, insbesondere weniger als 25 % und vorzugsweise weniger als 10 %. Die Tiefe 60 der Nut 54 ist weniger als 50 % größer als die Höhe des Kopfes 55 des Verbindungsmittels 56, insbesondere weniger als 25 % und vorzugsweise weniger als 10 %. Die Breite 59 der Nut 54 beträgt weniger als 90 % der Breite des Gleitmutterkanals 57, insbesondere weniger als 80 % und im Ausführungsbeispiels etwa 75 %. Die Breite 59 der Nut 54 entspricht etwa der Breite der den Tragschenkeln 52, 53 zugewandten Öffnung des Gleitmutterkanals 57. Die Tiefe 60 der Nut 54 beträgt weniger als 150 % der Tiefe des Gleitmutterkanals 57, insbesondere weniger als 100 % und vorzugsweise weniger als 50 %.

Das Verbindungsmittel 56 ist im Ausführungsbeispiel eine Flachkopfschraube, die in eine Durchgangsbohrung 61 im Montagesteg 3 eingesetzt ist und in eine Gewindebohrung des Montagebügels 5 eingeschraubt ist. Die Durchgangsbohrung 61 kann wahlfrei an einer für die Verbindung des Montagesteges 3 mit dem Montagebügel 5 geeigneten Stelle in den Montagesteg 3 eingebracht werden. Hierzu weist der Montagesteg 3 als Zentrierhilfe eine mittig in der Bodenfläche der Nut 54 eingebrachte, sich in Längsrichtung des Montagesteges 3 erstreckende und vorzugsweise V-förmige Rinne 62 auf.

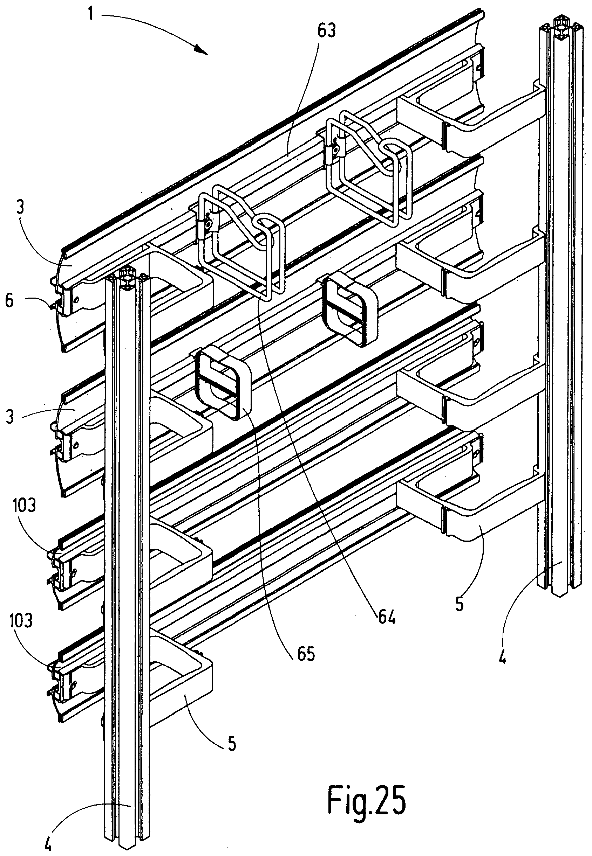

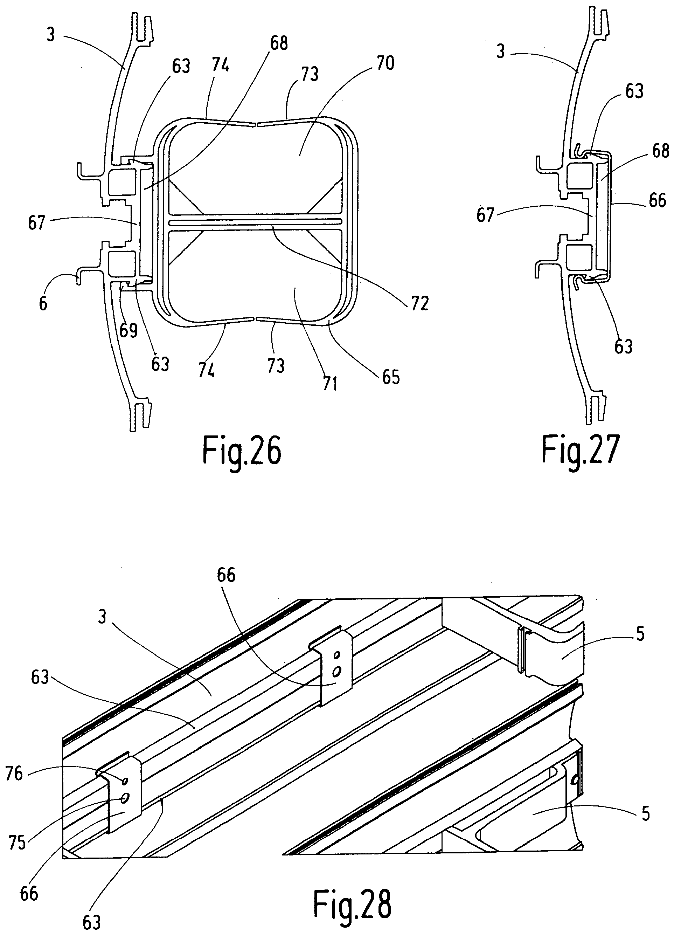

Die Fig. 25 zeigt eine perspektivische Ansicht auf die Rückseite des Montagesystems 1 der Fig. 1. Der Montagesteg 3 weist auf seiner der Tragschiene 6 gegenüberliegenden Rückseite mindestens einen sich in Längsrichtung des Montagesteges 3 erstreckenden Raststeg 63 auf, auf den weitere Komponenten 64, 65 des Montagesystems 1 unmittelbar aufrastbar sind oder mittelbar unter Verwendung eines aufrastbaren Adapterelements 66 (Fig. 27) festlegbar sind.

Die Fig. 26 zeigt eine Seitenansicht auf den Montagesteg 3 der Fig. 25. Der Montagesteg 3 weist in seinem mittleren Bereich auf der Rückseite zwei parallel verlaufende Raststege 63 auf, deren freie Enden gegenüber einem Verbindungssteg 67 vorspringen und dadurch eine Nut 68 bzw. einen Aufnahmeraum begrenzen, in den beispielsweise entweder der Montagebügel 5 eingelegt werden kann oder ein Verbindungselement eingreifen kann, beispielsweise ein Verbindungselement zum Verbinden einer weiteren Komponente 64 mit dem Adapterelement 66. Die Raststege 63 sind einstückig vom Montagesteg 3 ausgebildet.

Die Raststege 63 weisen eine selbsthemmende Rastkante 80 (Fig. 32) auf, insbesondere eine Rastkante 80 mit Hinterschnitt 81. Die beiden Raststege 63 verlaufen voneinander beabstandet aber parallel zueinander im Bereich der auf der Vorderseite angeordneten Tragschiene 6. Auf die Raststege 63 ist eine erste weitere Komponente 65 zum Bündeln von auf der Rückseite des Montagesteges 3 verlaufenden Verbindungsleitungen 34, 35 der auf der Vorderseite angeordneten Einrichtung 2 aufgerastet, die neben einem auf die Raststege 3 aufrastbaren Verbindungsabschnitt 69 auch zwei Bündelkammern 70, 71 aufweist für die Aufnahme von Verbindungsleitungen 34, 35. Die Bündelkammern 70, 71 sind symmetrisch zu einer Mittelebene, ebenso wie die doppelwandige Trennwand 72. Die beiden Bündelkammern 70, 71 sind jeweils über zwei federelastisch auslenkbare Schenkel 73, 74 von außen zugänglich, wobei die Schenkel 73, 74 auf einander gegenüberliegenden und an den Verbindungsabschnitt 69 angrenzenden Seiten angeordnet sind.

Die Fig. 27 zeigt eine Seitenansicht auf einen Montagesteg 3 mit einem auf die Raststege 63 aufgerasteten Adapterelement 66. Die Fig. 28 zeigt eine perspektivische Ansicht auf die Rückseite des Montagesteges 3 mit zwei aufgerasteten Adapterelementen 66. Das Adapterelement 66 weist eine vorzugsweise mittig angeordnete Bohrung 75 auf, die als Gewindebohrung ausgeführt sein kann oder ein angerolltes Gewinde, einen Gewindedurchzug, eine Einpressmutter oder dergleichen aufweisen kann, und eine oder mehrere, vorzugsweise exzentrisch angeordnete weitere Bohrungen 76 auf, die eine mechanische Schnittstelle für das Anbringen weiterer Komponenten des Montagesystems 1 auf der Rückseite des Montagesteges 3 bilden können. Die weitere Bohrung 76 kann beispielsweise ein Positioniermittel für das Anbringen weiterer Komponenten bilden, beispielsweise zum Einsetzen eines zugehörigen Positioniermittels der weiteren Komponente. Die Bohrungen 75, 76 korrespondieren mit dem durch das Adapterelement 66, die beiden Raststege 63 und den Verbindungssteg 67 begrenzten Aufnahmeraum 68.

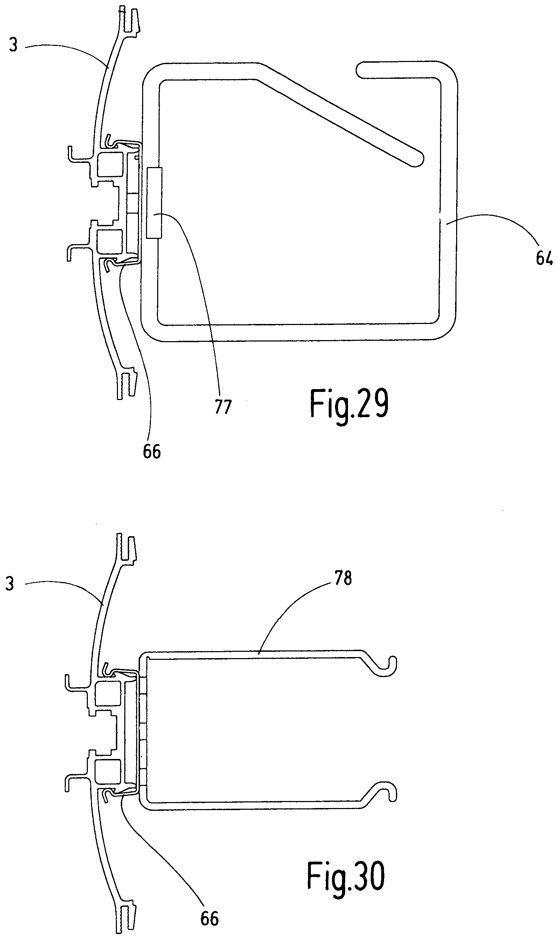

Die Fig. 29 zeigt eine zweite weitere Komponente 64 des Montagesystems 1, bei der es sich um ein weiteres Bündelelement zum Bündeln von Versorgungsleitungen 34, 35 handelt. Die zweite weitere Komponente 64 ist ein zweispuriges Drahtbiegeteil, das mittels eines mit dem Adapterelement 66 verschraubten Befestigungselements 77 klemmend an dem Adapterelement 66 festgelegt ist. Durch teilweises Lösen des Befestigungselements 77 wird die zweite weitere Komponente 64 zwar noch gehalten, ist aber gegenüber dem Adapterelement 66 entlang der beiden parallel zueinander verlaufenden Drahtspuren bewegbar und anschließend wieder klemmbar, so dass die gewünschte Position der zweiten weiteren Komponente 64 in Bezug auf das an den Raststegen 63 fixierte Adapterelement 66 bzw. den Montagesteg 3 einstellbar ist.

Die Fig. 30 zeigt eine Seitenansicht des Montagesteges 3 mit einem auf der Rückseite mittels des Adapterelements 66 auf den Montagesteg 3 aufgerasteten Kabelkanal 78.

Die Fig. 31 zeigt eine perspektivische Ansicht auf ein weiteres Ausführungsbeispiel eines Montagesystems 101, bei dem mindestens ein Montagesteg 403 an oder nahe seinen beiden Enden über ein Verbindungselement 79 mit jeweils einem vertikal verlaufenden Profilstab 4 verbunden ist. Das Verbindungselement 79 ist dabei aus einem Abschnitt eines Profils gebildet, aus dem auch der Profilstab 4 hergestellt ist. Alternativ kann auch ein sonstiges Distanzstück verwendet werden, beispielsweise ein Profilstück mit kleineren Querschnittsabmessungen oder auch eine auf den gewünschten Abstand des Montagesteges 403 von dem Profilstab 4 abgelängte Stange. Der Kopf 55 der Schraube, mittels welcher der Montagesteg 403 mit dem Verbindungselement 79 verbunden ist, liegt versenkt in der Nut 54 im Gleitmutterkanal 57.

Die Fig. 32 zeigt eine Seitenansicht auf ein weiteres Beispiel eines Montagesteges 503, der mittels eines Verbindungselements 79 an einem Profilstab 4 festlegbar ist. Das im Querschnitt vorzugsweise quadratische Verbindungselement 79 weist eine Kantenlänge auf, die dem Abstand der beiden Raststege 63 entspricht oder geringfügig kleiner ist, so dass die Raststege 63 durch einen Formschluss eine Führung beim Einsetzen des Verbindungselements 79 in den durch die Raststege 63 begrenzten Aufnahmeraum 68 (Fig. 27) bilden. Auch wenn anstelle des Verbindungselements 79 ein sonstiges Distanzstück verwendet wird, ist es vorteilhaft, wenn auch dieses einen Formschluss mit den Raststegen 63 aufweist, beispielsweise im Fall einer im Querschnitt runden oder verrundete Ecken aufweisenden Distanzstange, wenn diese mindestens an ihrem dem Montagesteg 503 zugewandten Endabschnitt zwei einander gegenüberliegende abgeflachte Seiten aufweist, deren Abstand dem Abstand der Raststege 63 entspricht.
Der Montagesteg 503 weist ebenso wie die zuvor beschriebenen Ausführungsbeispiele eine Aufnahmeeinrichtung 120 für Ordnungsmittel 8 oder weitere Komponenten 10 sowie einen Gleitmutterkanal 57 mit Nut 54 auf, aber der Montagesteg 503 weist keine Tragschiene 6 auf. Vielmehr werden die Einrichtungen 2 mittels Schrauben an dem Montagesteg 503 festgelegt, die mit im Gleitmutterkanal 57 angeordneten und dort verschiebbaren Muttern verschraubbar sind. Die nach beiden Seiten an den Gleitmutterkanal 57 anschließenden Abschnitte des Montagesteges 503 sind plan, beispielsweise für eine großflächige Anlage der festzulegenden Einrichtung 2. Die dem Gleitmutterkanal 57 abgewandten Enden der planen Abschnitte sind rechtwinklig abgebogen und bilden abschließend jeweils eine Aufnahmeeinrichtung 120 aus, die gegenüber der durch die planen Abschnitte bestimmten Ebene zurückversetzt sind.

Die Fig. 33 zeigt eine Seitenansicht auf ein weiteres Beispiel eines Montagesteges 603, der mittels eines Verbindungselements 79 an einem Profilstab 4 festlegbar ist. Der Montagesteg 603 weist auf seiner Vorderseite eine konvexe Krümmung auf, an deren Position größter Vorwölbung eine Tragschiene 6 angeordnet ist. Während die Tragschiene 6 und auch der Gleitmutterkanal 57 mit der Nut 54 symmetrisch zu einer Mittelebene 40 sind, ist das Profil des Montagesteges 603 unsymmetrisch zu dieser Mittelebene 40. Der auf der einen Seite an die Tragschiene 6 anschließende und an der Aufnahmeeinrichtung 120 endende zweite Abschnitt 142 weist in lateraler Richtung eine größere Erstreckung auf als der auf der anderen Seite an die Tragschiene 6 anschließende zweite Abschnitt 242. Demgegenüber ist der Höhenabstand 44, den die beiden zweiten Abschnitte 142, 242 überstreichen, übereinstimmend.

## Patentansprüche

1. Montagesystem (1) für die Anordnung von beispielsweise elektrischen Einrichtungen (2) in Schaltschränken, wobei das Montagesystem (1) mindestens einen vorzugsweise horizontal verlaufenden Montagesteg (3) aufweist, an dem mindestens eine Einrichtung (2) anbringbar ist, und wobei der Montagesteg (3) an einem ersten, in einem Schnitt quer zur Längsachse durch den Montagesteg (3) vorzugsweise mittigen Abschnitt (41) eine Tragschiene (6) aufweist, an der die Einrichtung (2) lösbar festlegbar ist, wobei ein von der Tragschiene (6) quer zur Längsachse des Montagestegs (3) beabstandeter dritter Abschnitt (43) des Montagesteges (3) einen größeren Höhenabstand (44) von dem Fußpunkt (39) der Tragschiene (6), gemessen in Richtung der Tragschienenhöhe, aufweist als ein zwischen dem ersten Abschnitt (41) und dritten Abschnitt (43) angeordneter zweiter Abschnitt (42) an seinem der Tragschiene (6) nahen, insbesondere an die Tragschiene (6) angrenzenden Ende, **dadurch gekennzeichnet, dass** der Montagesteg (3) mindestens abschnittsweise eine konvexe Krümmung aufweist und dass dadurch der erste Abschnitt (41) des Montagesteges (3) mit der Tragschiene (6) nach außen gewölbt ist.

2. Montagesystem (1) nach Anspruch 1, **dadurch gekennzeichnet, dass** der Höhenabstand (44) des dritten Abschnitts (43) von dem Fußpunkt (39) der Tragschiene (6) mehr als 50 % und weniger als 200 %, insbesondere mehr als 80 % und weniger als 125 % und vorzugsweise etwa 100 % des Höhenabstandes (45) von dem Fußpunkt (39) der Tragschiene (6) bis zu einem von dem Montagesteg (3) entfernten, beim Festlegen der Einrichtung (2) mit der Einrichtung (2) zusammenwirkenden Abschnitt der Tragschiene (6) beträgt.

3. Montagesystem (1) nach einem der vorangehenden Ansprüche, **dadurch gekennzeichnet, dass** der Montagesteg (3) die konvexe Krümmung in dem zweiten Abschnitt (42) aufweist.

4. Montagesystem (1) nach einem der vorangehenden Ansprüche, **dadurch gekennzeichnet, dass** die konvexe Krümmung sich mindestens einseitig, vorzugsweise beidseitig, über einen Winkelbereich von gegebenenfalls jeweils mehr als 8° und weniger als 30° erstreckt, insbesondere mehr als 10° und weniger als 25°, und vorzugsweise mehr als 12° und weniger als 20°.

5. Montagesystem (1) nach einem der vorangehenden Ansprüche, **dadurch gekennzeichnet, dass** der Radius der konvexen Krümmung mehr als das Zweifache, insbesondere mehr als das Dreifache und vorzugsweise mehr als das Vierfache der lateralen Erstreckung des gekrümmten zweiten Abschnitts (42) beträgt.

6. Montagesystem (1) nach einem der vorangehenden Ansprüche, **dadurch gekennzeichnet, dass** der Montagesteg (3) entlang seiner Längserstreckung eine Nut (47) zum lösbar rastenden Einsetzen von Bezeichnungsschildern (48) aufweist.

7. Montagesystem (1) nach einem der vorangehenden Ansprüche, **dadurch gekennzeichnet, dass** die Nut (47) einen Hinterschnitt (49) aufweist, in den die in die Nut (47) einsetzbaren Bezeichnungsschilder (48) mit federnd auslenkbaren Schenkeln (50) rastend eingreifen.

8. Montagesystem (1) nach einem der vorangehenden Ansprüche, **dadurch gekennzeichnet, dass** die Nut (47) im Bereich des dritten Abschnitts (43) des Montagesteges (3) angeordnet ist oder in dem vom ersten Abschnitt (41) fernen Ende des zweiten Abschnitts (42) des Montagesteges (3).

9. Montagesystem (1) nach einem der vorangehenden Ansprüche, **dadurch gekennzeichnet, dass** der Montagesteg (3) an mindestens einem von der Tragschiene (6) fernen freien Ende eine Aufnahmeeinrichtung (20) für ein an dem Montagesteg (3) festlegbares Ordnungsmittel (8) aufweist zum Ordnen der Verbindungsleitungen (34, 35) der an dem Montagesteg (3) anzubringenden Einrichtung (2).

## Claims

1. Mounting system (1) for the arrangement of, for example, electrical devices (2) switch cabinets, wherein the mounting system (1) has at least one, preferably horizontally extending, mounting web (3) to which at least one device (2) can be attached, and the mounting web (3) having a support rail (6) on a first section (41), preferably in a section transverse to the longitudinal axis through the mounting web (3), to which the device (2) can be detachably fastened,
wherein a third portion (43) of the mounting web (3) spaced transversely to the longitudinal axis of the mounting rail (6) has a greater height distance (44) from the base point (39) of the mounting rail (6), measured in the direction of the mounting rail height, than a second portion (42) arranged between the first portion (41) and third portion (43) at its end close to the mounting rail (6), in particular at the end adjacent to the mounting rail (6),
**characterised in that** the support strip (3) has a convex curvature at least section wise and that thereby the first section (41) of the support strip (3) is arched outwards with the mounting rail (6).

2. Mounting system (1) according to Claim 1, **characterised in that** the height distance (44) of the third section (43) from the base point (39) of the mounting rail (6) is more than 50 % and less than 200 %, in particular more than 80 % and less than 125 % and preferably about 100 % of the height distance (45) from the base point (39) of the mounting rail (6) to a section of the mounting rail (6) remote from the support strip (3) and interacting with the device (2) when the device (2) is fastened.

3. A mounting system (1) according to one of the preceding Claims, **characterised in that** the support strip (3) has the convex curvature in the second section (42).

4. Mounting system (1) according to one of the preceding Claims, **characterised in that** the convex curvature extends on at least one side, preferably on both sides, over an angular range of optionally more than 8° and less than 30°, in particular more than 10° and less than 25°, and preferably more than 12° and less than 20°.

5. Mounting system (1) according to one of the preceding Claims, **characterised in that** the radius of the convex curvature is more than twice, in particular more than three times and preferably more than four times the lateral extension of the curved second section (42).

6. Mounting system (1) according to one of the preceding Claims, **characterised in that** the support strip (3) has a groove (47) along its longitudinal extent for detachable locking insertion of inscription labels (48).

7. Mounting system (1) according to one of the preceding Claims, **characterised in that** the groove (47) has an undercut (49) into which the inscription labels (48) which can be inserted into the groove (47) engage in a latching manner with flexibly deflectable legs (50).

8. Assembly system (1) according to one of the preceding Claims, **characterised in that** the groove (47) is arranged in the region of the third section (43) of the support strip (3) or in the end of the second section (42) of the support strip (3) remote from the first section (41).

9. Mounting system (1) according to one of the above Claims, **characterised in that** the mounting web (3) has, at least one free end remote from the mounting rail (6), a receiving device (20) for an arrangement means (8) which can be fixed to the support strip (3) for arranging the connection lines (34, 35) of the device (2) to be attached to the support strip (3).

## Revendications

1. Système (1) d'assemblage pour le montage par exemple d'équipements (2) électriques dans des armoires électriques, dans lequel le système (1) d'assemblage ayant au moins une entretoise (3) d'assemblage, qui s'étend de préférence horizontalement et sur laquelle peut être monté le au moins un équipement (2) et dans lequel l'entretoise (3) d'assemblage a, sur un premier tronçon (41) de préférence médian, dans une coupe transversalement à l'axe longitudinal de l'entretoise (3) d'assemblage, un rail (6) porteur auquel l'équipement (2) peut être fixé de manière amovible, dans lequel un troisième tronçon (43), à distance du rail (6) porteur transversalement à l'axe longitudinal de l'entretoise (3) de montage, de l'entretoise (3) de montage, a une distance (44) en hauteur plus grande, du pied (39) du rail (6) porteur, mesurée dans la direction en hauteur du rail porteur, qu'un deuxième tronçon (42), disposé entre le premier tronçon (41) et le troisième tronçon (43) à son extrémité près du rail (6) porteur, notamment voisine du rail (6) porteur, **caractérisé en ce que** l'entretoise (3) d'assemblage a, au moins par tronçon, une courbure convexe et **en ce qu'**ainsi le premier tronçon (41) de l'entretoise (3) d'assemblage, ayant le rail (6) porteur, est courbé vers l'extérieur.

2. Système (1) d'assemblage suivant la revendication 1, **caractérisé en ce que** la distance (44) en hauteur du troisième tronçon (43) au pied (39) du rail (6) porteur représente plus de 50% et moins de 200%, notamment plus de 80% et moins de 125% et de préférence à peu près 100% de la distance (45) en hauteur du pied (39) du rail (6) porteur à un tronçon du rail (6) porteur, éloigné de l'entretoise (3) d'assemblage et coopérant avec l'équipement (2) lors de la fixation de l'équipement (2).

3. Système (1) d'assemblage suivant l'une des revendications précédentes, **caractérisé en ce que** l'entretoise (3) d'assemblage a la courbure convexe dans le deuxième tronçon (42) .

4. Système (1) d'assemblage suivant l'une des revendications précédentes, **caractérisé en ce que** la courbure convexe s'étend au moins d'un côté, de préférence des deux côtés, sur une plage angulaire de, le cas échéant, respectivement plus de 8° et de moins de 30°, notamment de plus de 10° et de moins de 25°, et de préférence de plus de 12° et de moins de 20°.

5. Système (1) d'assemblage suivant l'une des revendications précédentes, **caractérisé en ce que** le rayon de la courbure convexe représente plus de deux fois, notamment plus de trois fois, et de préférence plus de quatre fois l'étendue latérale du deuxième tronçon (42) courbé.

6. Système (1) d'assemblage suivant l'une des revendications précédentes, **caractérisé en ce que** l'entretoise (3) d'assemblage a, le long de son étendue longitudinale, une rainure (47) pour l'insertion par encliquetage amovible de panneaux (48) d'inscription.

7. Système (1) d'assemblage suivant l'une des revendications précédentes, **caractérisé en ce que** la rainure (47) a une contre-dépouille (49) dans laquelle les panneaux (48) d'inscription, pouvant être insérés dans la rainure (47), pénètrent en s'encliquetant par des branches (50) pouvant être déviées élastiquement.

8. Système (1) d'assemblage suivant l'une des revendications précédentes, **caractérisé en ce que** la rainure (47) est disposée dans la partie du troisième tronçon (43) de l'entretoise (3) d'assemblage ou à l'extrémité, loin du premier tronçon (41), du deuxième tronçon (42) de l'entretoise (3) d'assemblage.

9. Système (1) d'assemblage suivant l'une des revendications précédentes, **caractérisé en ce que** l'entretoise (3) d'assemblage a, à au moins une extrémité libre loin du rail (6) porteur, un dispositif (20) de réception d'un moyen (8) de mise en ordre pouvant être fixé à l'entretoise (3) d'assemblage pour la mise en ordre des lignes (34, 35) de liaison de l'équipement (2) pouvant être monté sur l'entretoise (3) d'assemblage.
